# EUROPEAN PATENT APPLICATION

(11) **EP 4 647 836 A1**
(43) Date of publication of application: **12.11.2025**
(21) Application number: 24209062.9
(22) Date of filing: 25.10.2024
(51) Int. Cl.: G03F 1/00, G03F 7/00

(54) **WAFER EXPOSURE LAYOUT METHOD**

(30) Priority: 07.05.2024 TW 113116815
(71) Applicant: Taiwan-Asia Semiconductor Corporation, Hsinchu City 30078 (TW)
(72) Inventor: LIN, Chun-Chieh, 30078 Hsinchu City (TW); YANG, Zhi-Wei, 30078 Hsinchu City (TW)
(74) Representative: Michalski Hüttermann & Partner Patentanwälte mbB

(57) **Abstract**

The invention provides a wafer exposure layout method. First, a plurality of linear exposure paths for the wafer are planned. Each linear exposure path includes a plurality of rectangular exposure field areas arranged side by side along a straight line, and any rectangular exposure field area partially overlaps another adjacent rectangular exposure field area. Then a photomask with a honeycomb structure composed of a plurality of completely regular hexagonal units is provided. The photomask moves one by one along the plurality of linear exposure paths, and when the photomask moves along any linear exposure path, the photomask is moved one by one along the plurality of rectangular exposure field areas. A side of the photomask that moves to a first exposure position in any rectangular exposure field area is partially embedded with an opposite side of the photomask that moves to a second exposure position in another adjacent rectangular exposure field area.

## Description

### BACKGROUND OF THE INVENTION

### 1. Field of the Invention

The present invention relates to a wafer exposure layout method, especially a wafer exposure layout method for improving a utilization rate of a wafer.

### 2. Description of Related Art

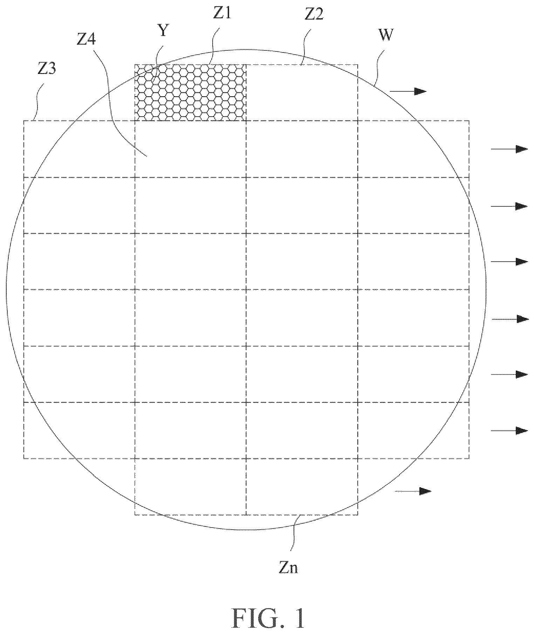

Conventional stepper exposure equipment can be applied to exposure processes of large-area wafers. A dynamic movement way of single field exposure is adopted for the stepper exposure equipment. As shown in FIG. 1, for the stepper exposure equipment, a plurality of field areas of Z1 to Zn are first planned for a wafer W, and then an exposure process, through a photomask, is performed on a partial area of the wafer W corresponding to the single field area Z1. When the single field area Z1 is completely exposed, a relative movement between the wafer W and the photomask is carried out, so that the photomask can perform exposure on another partial area of the wafer corresponding to next single field area Z2. The above operation is repeated until all of the planned field areas of the entire wafer are exposed.

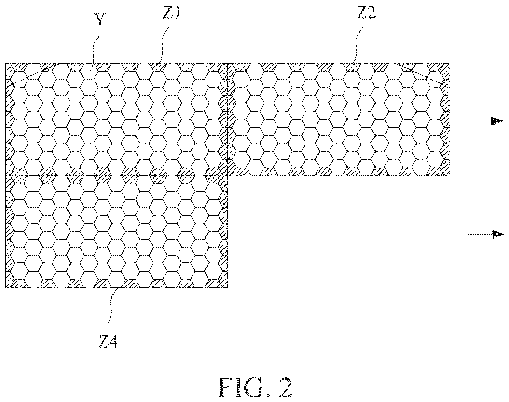

Taking the wafer W with hexagonal dies as an example, as shown in FIG. 1 and FIG. 2, a conventional photomask Y applied therein is designed to be a rectangular structure conforming to a size of the field area, with complete hexagonal units in the interior of the rectangular structure to fit hexagonal dies one by one. Since two adjacent field areas (for example, the two laterally adjacent field areas Z1 and Z2 or the two longitudinally adjacent field areas Z1 and Z4) are connected to each other on corresponding sides, when the exposure processes for multiple field areas Z1 to Zn are performed one by one through the photomask, alignment errors are easily occurred between two adjacent field areas, causing that some hexagonal units of one field area are unable to be completely aligned with some hexagonal units of another adjacent field area (shown as diagonal-lined areas in FIG. 2). Accordingly, some of the hexagonal dies corresponding to those hexagonal units are not completely exposed, which leads to a significant reduction of utilization rate of the wafer and causes losses.

In light of this, it is really worthy of research and development to design a wafer exposure layout method for solving those above-mentioned problems.

### SUMMARY OF THE INVENTION

An objective of the present invention is to provide a wafer exposure layout method applied for polygonal dies and for improving a utilization rate of a wafer.

The wafer exposure layout method of the present invention is for performing step-and-repeat exposing of polygonal dies pre-formed on a wafer. To achieve the above mentioned objective, the wafer exposure layout method comprises following steps. Plan a plurality of linear exposure paths that are parallel and equidistant from each other, wherein each linear exposure path includes a plurality of rectangular exposure field areas arranged side by side along a straight line, any of the rectangular exposure field areas partially overlaps an adjacent rectangular exposure field area, and each of the rectangular exposure field areas covers a portion of the wafer. Provide a photomask composed of a plurality of completely regular hexagonal units to form a honeycomb structure, so that concave and convex edges form for each side of the photomask, wherein each completely regular hexagonal unit corresponds to at least one of the plurality of polygonal dies. And move the photomask one by one along a plurality of linear exposure paths relative to the wafer, wherein when the photomask moves along any of linear exposure paths, it is moved one by one along the plurality of rectangular exposure field areas which are side by side, to expose the wafer. When the photomask correspondingly moves to a first exposure position of any of the rectangular exposure field areas, each side of the photomask partially contacts each side of the rectangular exposure field area, and when the photomask moves to a second exposure position in another adjacent rectangular exposure field area, at least one side of the photomask partially embeds with a corresponding side of the adjacent rectangular exposure field area.

In one embodiment of the present invention, a plurality of convex portions and a plurality of concave portions are respectively formed for each side of the photomask. The plurality of convex portions of at least one side of the photomask, as being moved to the first exposure position in any of the rectangular exposure field areas, are partially embedded with the plurality of concave portions of a correspondingly side of the photomask, being relatively moved to the second exposure position in another adjacent rectangular exposure field area, and the plurality of concave portions of the at least one side of the photomask are partially embedded with the plurality of convex portions of the correspondingly side of the photomask, being relatively moved to the second exposure position in another adjacent rectangular exposure field area.

In one embodiment of the present invention, a partially overlapping area extending inward from a short side of any of the rectangular exposure field areas overlaps a partially overlapping area extending inward from a short side of another laterally adjacent rectangular exposure field area, in each of the linear exposure paths.

In one embodiment of the present invention, a partially overlapping area extending inward from a long side of any of the rectangular exposure field areas in each of the linear exposure paths overlaps a partially overlapping area extending inward from a long side of another longitudinally adjacent rectangular exposure field area in another of the linear exposure paths.

In one embodiment of the present invention, a partially overlapping area extending inward from an angle between a long side and a short side of any of the rectangular exposure field areas in each of the linear exposure paths overlaps a partially overlapping area extending inward from an angle between a long side and a short side of another diagonally adjacent rectangular exposure field area in another of the linear exposure paths.

In one embodiment of the present invention, when the photomask is correspondingly moved to any of the rectangular exposure field areas, a position of any of the completely regular hexagonal units corresponds to a position of at least one of the plurality of polygonal dies.

In one embodiment of the present invention, each completely regular hexagonal unit is composed of a plurality of polygonal subunits, and wherein when the photomask is correspondingly moved to any of the rectangular exposure field areas, a position of any of the polygonal subunits corresponds to a position of at least one of the plurality of polygonal dies.

In one embodiment of the present invention, each of the polygonal subunit is equilateral triangular or regular trapezoidal.

In one embodiment of the present invention, each of the polygonal dies is equilateral triangular, equilateral trapezoidal or regular hexagonal.

In one embodiment of the present invention, a plurality of rows of completely regular hexagonal unit groups are formed by the plurality of completely regular hexagonal units, and any of the rows of completely regular hexagonal unit groups is connected to another adjacent row of completely regular hexagonal unit group in a staggered manner, so as to form the honeycomb structure.

The present invention also provides a photomask utilized in the aforementioned wafer exposure layout method. The photomask is composed by a plurality of completely regular hexagonal units to form a honeycomb structure, so that concave and convex edges form for each side of the photomask, and each of the completely regular hexagonal unit corresponds to at least one of a plurality of polygonal dies.

### BRIEF DESCRIPTION OF THE DRAWINGS

FIG. 1 is a schematic view of a conventional stepper exposure equipment performing a wafer exposure process according to the present invention;
FIG. 2 is a schematic view of an exposure status of two adjacent field areas as the conventional stepper exposure equipment performing the wafer exposure process according to the present invention;
FIG. 3 is a flowchart of a wafer exposure layout method according to the present invention;
FIG. 4 is a schematic view of a plurality of linear exposure paths programmed in the wafer exposure layout method according to the present invention;
FIG. 5 is a schematic view of a photomask utilized in the wafer exposure layout method according to the present invention;
FIG. 6 is a schematic view of a moving trajectory of the photomask relative to a wafer along the plurality of linear exposure paths of the wafer exposure layout method according to the present invention;
FIG. 7 is a schematic view of a trajectory of the photomask within a single rectangular field area of the wafer exposure layout method according to the present invention;
FIG. 8 is a schematic view of a trajectory of the photomask within two laterally adjacent field areas of the wafer exposure layout method according to the present invention;
FIG. 9 is a schematic view of a trajectory of the photomask within two longitudinally adjacent field areas of the wafer exposure layout method according to the present invention;
FIG. 10 is a schematic view of a trajectory of the photomask within two diagonally adjacent field areas of the wafer exposure layout method according to the present invention;
FIG. 11A is a schematic view of another photomask utilized in another embodiment of the wafer exposure layout method according to the present invention;
FIG. 11B is a schematic view of yet another photomask utilized in yet another embodiment of the wafer exposure layout method according to the present invention.

### DETAILED DESCRIPTION OF THE PREFERRED EMBODIMENT

Since various examples and embodiments in the present invention are only illustrative and non-restrictive, a person skilled in the art can easily conceive other examples and embodiments without contravening the scope of the present invention, after reading this specification, and can make the features and advantages of these embodiments more evident based on the following detailed description and claims.

Herein, the description of unit, element and component in the present invention uses "one", "a", or "an". This is for convenience and for offering general meaning of the category of the present invention. Therefore, the description should be understood as including "one", "at least one", and singular and plural forms at the same time unless the context clearly indicates otherwise.

Herein, the description of the terms "first" or "second" and similar ordinal numbers are mainly used to distinguish or refer to the same or similar elements or structures and do not necessarily imply that such components or structures are spatially or temporally distinct order. It should be understood that ordinal numbers, in certain situations or configurations, may be used interchangeably without affecting the implementation of the present invention.

Herein, the description of "comprise", "have" or other similar semantics have the non-exclusive meaning. For example, components or structures with a plurality of elements are not only limited to those disclosed in this specification, but also include generally inherent elements, which are not explicitly listed here for the components or the structures.

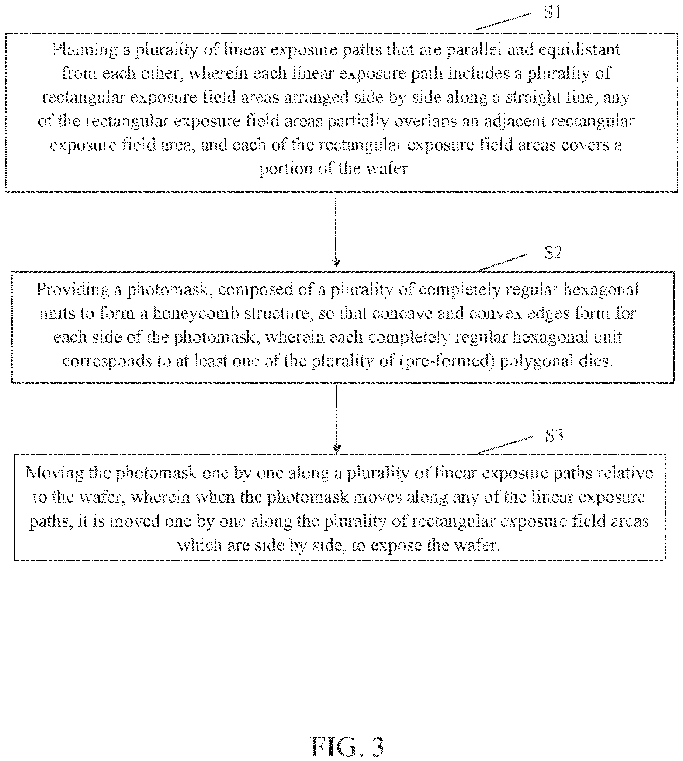

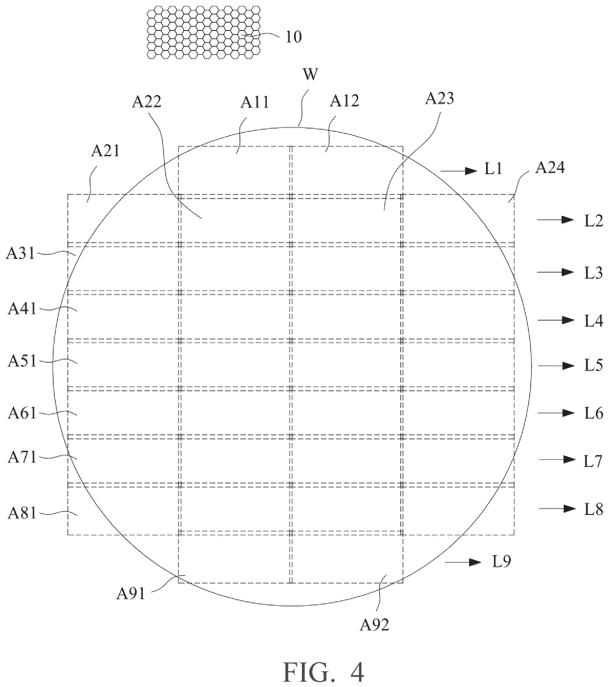

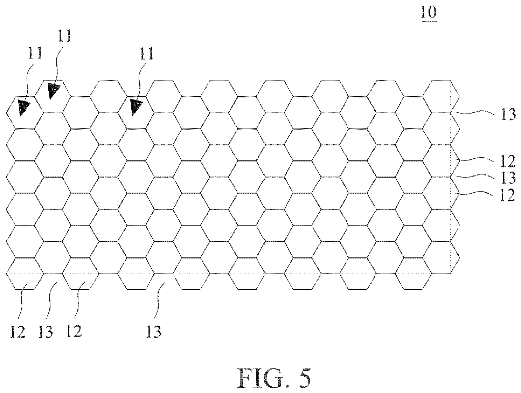

The wafer exposure layout method of the present invention is mainly applied in stepper exposure equipment to perform step-and-repeat exposure on a plurality of pre-formed polygonal dies of a wafer, the plurality of pre-formed polygonal dies of the wafer are planned according to needs. In the present invention, each polygonal die is in a shape of an equilateral triangle, an equilateral trapezoid or a regular hexagon, but the invention is not limited thereto. Please refer to FIG. 3 to FIG. 5 below. FIG. 3 is a flow chart of the wafer exposure layout method of the present invention. FIG. 4 is a schematic view of a plurality of linear exposure paths programmed in the wafer exposure layout method according to the present invention. FIG. 5 is a schematic view of a photomask utilized in the wafer exposure layout method according to the present invention. As shown in FIG. 3, the wafer exposure layout method of the present invention includes steps as follows.

Step S1: planning a plurality of linear exposure paths that are parallel and equidistant from each other, wherein each linear exposure path includes a plurality of rectangular exposure field areas arranged side by side along a straight line, any of the rectangular exposure field areas partially overlaps an adjacent rectangular exposure field area, and each of the rectangular exposure field areas covers a portion of the wafer.

Since an overall exposure area of the photomask for exposing is smaller than an overall area of the wafer, when performing step exposure on the wafer, it is necessary to move the photomask gradually along set linear exposure paths relative to the wafer, and to let a moving range of the photomask cover the entire area of the wafer as much as possible. As shown in FIG. 4, for the present invention, a plurality of linear exposure paths L1 to L9 are first programmed for the wafer W to be exposed, and these linear exposure paths L1 to L9 are parallel to each other and arranged equidistantly. In fact, a number and a distance of the plurality of linear exposure paths L1 to L9 will be changed depending on the overall area of the wafer W and the overall area of the photomask 10.

Each linear exposure path includes a plurality of rectangular exposure field areas, and the plurality of rectangular exposure field areas are arranged side by side along a straight line and are laterally aligned with each other. In FIG. 4, taking the linear exposure path L1 as an example, it includes a plurality of rectangular exposure field areas A11 and A12 which are arranged side by side along a straight line and laterally aligned with each other; taking the linear exposure path L2 as an example, it includes a plurality of rectangular exposure field areas A21 to A24 which are arranged side by side along a straight line and laterally aligned with each other; ... and so on. Multiple rectangular exposure field areas, located on different linear exposure paths, are also be arranged side by side and longitudinally aligned with each other along another straight line perpendicular to the different linear exposure paths respectively. For example, the rectangular exposure field areas A21 to A81 are arranged side by side along a longitudinal straight line and are longitudinally aligned with each other. In fact, a number and an area of the plurality of rectangular exposure field areas will vary depending on the overall area of the wafer W and the overall area of the photomask 10.

Each rectangular exposure field area covers a part of the wafer W, so that when the photomask 10 is correspondingly moved to a target rectangular exposure field area, the photomask 10 is utilized for exposure relative to a partial area of the wafer W. Each rectangular exposure field area may include two long sides and two short sides. In the present invention, any rectangular exposure field area partially overlaps another adjacent rectangular exposure field area. The word of "adjacent" here is defined as other rectangular exposure field areas that surround any target rectangular exposure field area and are in contact (with points or lines) with the target rectangular exposure field area. As the relative positions of two adjacent rectangular exposure field areas are different (for example, arranged along the same linear exposure path or along different linear exposure paths), the overlapping positions of the two adjacent rectangular exposure field areas will also be different. For example, two adjacent rectangular exposure field areas can appear in a longitudinal, lateral or diagonal pattern.

In one embodiment of the present invention, a partially overlapping area extending inward from a short side of any rectangular exposure field area in each linear exposure path overlaps a partially overlapping area extending inward from a short side of another laterally adjacent rectangular exposure field area. That is to say, for the same linear exposure path, an area within one of the short sides of any rectangular exposure field area will cross the corresponding short side of another laterally adjacent rectangular exposure field area, and will enter into another laterally adjacent rectangular exposure field area, such as the laterally adjacent rectangular exposure field areas A11 and A12 located in the same linear exposure path L1.

In one embodiment of the present invention, a partially overlapping area extending inward from a long side of any rectangular exposure field area in each linear exposure path overlaps a partially overlapping area extending inward from a long side of another longitudinally adjacent rectangular exposure field area. That is to say, for two adjacent different linear exposure paths, an area within one of the long sides of any rectangular exposure field area will cross the corresponding long side of another longitudinally adjacent rectangular exposure field area, and will enter into another longitudinally adjacent rectangular exposure field area, such as the rectangular exposure field area A11 located in the linear exposure path L1 and the longitudinally adjacent rectangular exposure field area A22 located in the linear exposure path L2.

In one embodiment of the present invention, a partially overlapping area extending inward from an angle between a long side and a short side of any rectangular exposure field area in each linear exposure path overlaps a partially overlapping area extending inward from an angle between a long side and a short side of another diagonally adjacent rectangular exposure field area. That is to say, for two adjacent different linear exposure paths, an area within one of the angles between the long side and the short side of any rectangular exposure field area will cross the corresponding angle between the long side and the short side of another diagonally adjacent rectangular exposure field area, and will enter into another diagonally adjacent rectangular exposure field area, such as the rectangular exposure field area A11 located in the linear exposure path L1 and the diagonally adjacent rectangular exposure field area A21 located in the linear exposure path L2.

Accordingly, duo to partially overlapping each other of the plurality of rectangular exposure field areas A11 to A92 in the plurality of linear exposure paths L1 to L9 and due to being regularly arranged along the lateral straight lines and the longitudinal straight lines, the wafer W can be closely covered by the plurality of rectangular exposure areas of A11 to A92, approximately.

Step S2: providing a photomask, composed of a plurality of completely regular hexagonal units to form a honeycomb structure, so that concave and convex edges form for each side of the photomask, wherein each completely regular hexagonal unit corresponds to at least one of the plurality of (pre-formed) polygonal dies.

After a plurality of linear exposure paths in the aforementioned step S1 are planned, for the present invention, a photomask 10 for exposing the wafer W is provided. As shown in FIG. 4 and FIG. 5, in this embodiment, the photomask 10 is composed of a plurality of completely regular hexagonal units 11 to form a honeycomb structure. That is to say, no incompletely regular hexagonal unit exits in the photomask 10. A shape and a size of each completely regular hexagonal unit 11 conforms to a shape and a size of a single polygonal die of the wafer, or conforms to a overall shape and a overall size of a combination of multiple polygonal dies. The photomask 10 is able to entirely enter one rectangular exposure field area, and is composed of a maximum number of completely regular hexagonal units 11, so as to fill an entire area of one rectangular exposure field area as much as possible.

In one embodiment of the present invention, a plurality of rows of completely regular hexagonal unit groups are formed by the plurality of completely regular hexagonal units 11, and any row of completely regular hexagonal unit groups is connected to another adjacent row of completely regular hexagonal unit group in a staggered manner, thus to form the honeycomb structure. For example, as shown in FIG. 5, each row of completely regular hexagonal unit groups is composed of six completely regular hexagonal units 11 arranged longitudinally, and sixteen rows of completely regular hexagonal unit groups are arranged laterally with each other in a staggered manner, so that the overall honeycomb structure thereby constructed is approximately constrained to one single rectangular exposure area being designed. But the number of completely regular hexagonal units 11 contained by each row of completely regular hexagonal unit groups and the number of rows of completely regular hexagonal unit groups are not limited as above, they can be changed according to different structural designs or needs.

Accordingly, each side of the photomask 10 (i.e., based on a perspective of FIG. 5, four sides generally located upper, lower, left and right of the photomask 10, except for the two opposite large area exposure surfaces), will have concave and convex edges due to structural combination restrictions of the plural completely regular hexagonal units 11. The concave and convex edges mentioned here mean that each side of the photomask 10 will form a concave and convex contour similar to a concave and convex contour of a puzzle piece, rather than a flat edge contour of a straight line.

Furthermore, a plurality of convex portions 12 and a plurality of concave portions 13 are formed on each side of the photomask 10, and the plurality of convex portions 12 and the plurality of concave portions 13 on each side are generally staggered with each other and regularly arranged. Any convex portion 12 or concave portion 13 is one part of a completely regular hexagonal unit 11. Structurally, the two opposite sides of the photomask 10 (i.e., the two opposite long sides or the two opposite short sides) have convex portions 12 or concave portions 13 with matched shapes and sizes, and the shapes and sizes of the convex portions 12 correspondingly fit the shapes and sizes of the concave portions 13. On the other hand, the two adjacent sides of the photomask 10 (that is, the long side and the short side that are adjacent and form an included angle) have convex portions 12 or concave portions 13 with mismatched shapes and sizes.

Step S3: moving the photomask one by one along a plurality of linear exposure paths relative to the wafer, wherein when the photomask moves along any of the linear exposure paths, it is moved one by one along the plurality of rectangular exposure field areas which are side by side, to expose the wafer.

After the photomask 10 is provided in the aforementioned step S2, for the present invention, the photomask 10 shifts relative to the wafer W along a plurality of linear exposure paths one by one to expose the wafer W. When the photomask 10 moves along any linear exposure path, it sequentially transfers one by one along the plurality of rectangular exposure field areas arranged side by side along the linear exposure path, to perform stepper exposing.

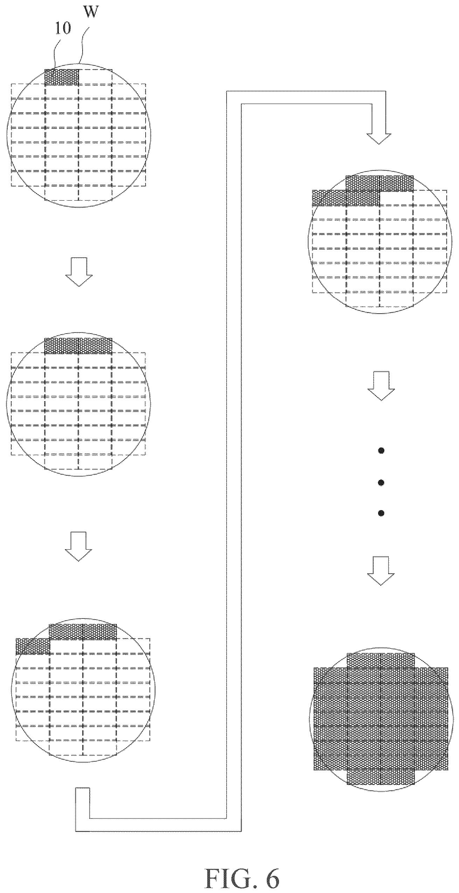

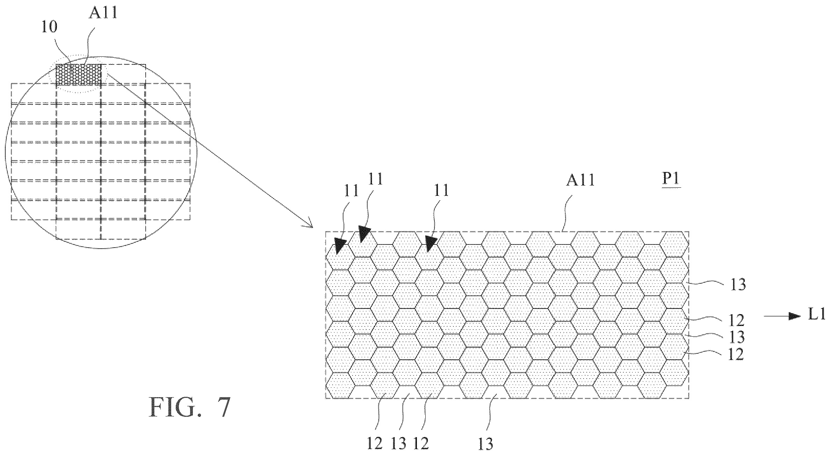

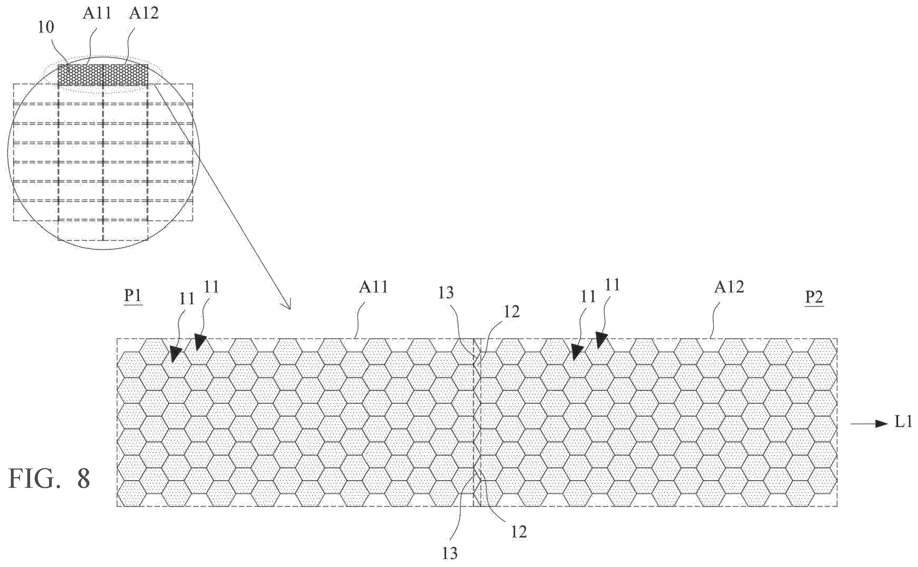

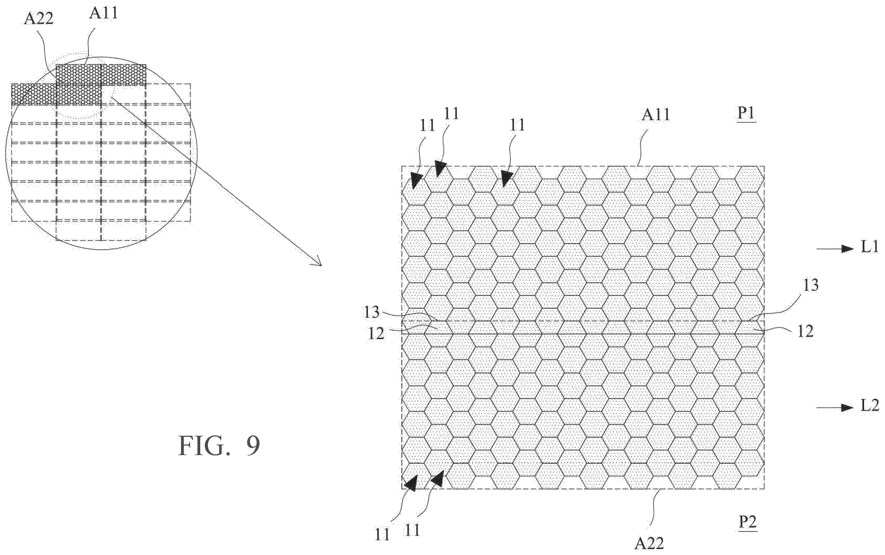

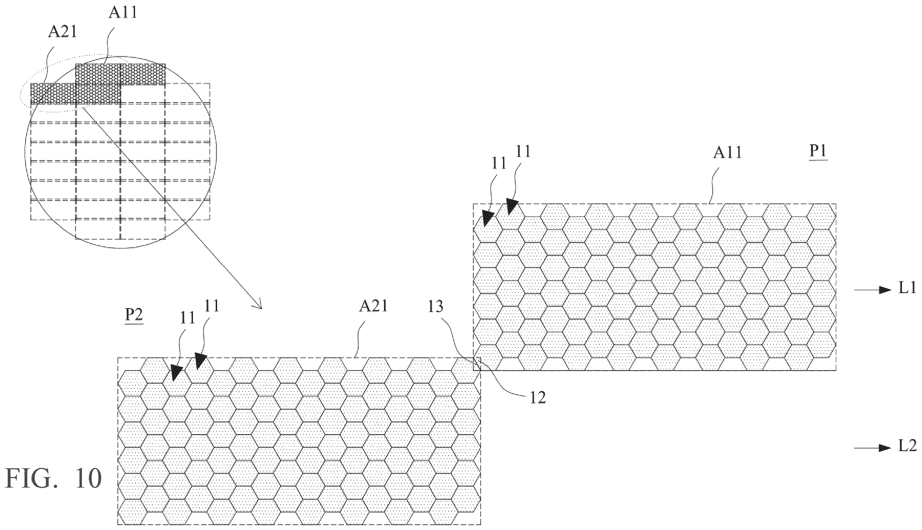

Please refer to FIG. 4 and FIG. 6 to FIG. 10 together. FIG. 6 is a schematic view of a moving trajectory of the photomask moving relative to a wafer along the plurality of linear exposure paths of the wafer exposure layout method according to the present invention, FIG. 7 is a schematic view of a trajectory of the photomask within a single rectangular field area of the wafer exposure layout method according to the present invention, FIG. 8 is a schematic view of a trajectory of the photomask within two laterally adjacent field areas of the wafer exposure layout method according to the present invention, FIG. 9 is a schematic view of a trajectory of the photomask within two longitudinally adjacent field areas of the wafer exposure layout method according to the present invention, and FIG. 10 is a schematic view of a trajectory of the photomask within two diagonally adjacent field areas of the wafer exposure layout method according to the present invention. As shown in FIG. 4 and FIG. 6, it is assumed that nine linear exposure paths L1 to L9 parallel to each other are planned for the wafer W and a plurality of rectangular exposure field areas are arranged side by side along each linear exposure path. To begin with, the photomask 10 will, along the first linear exposure path L1, move sequentially from the first rectangular exposure field area A11 to the second rectangular exposure field area A12, and then will, along the second linear exposure path L2 adjacent to the first linear exposure path L1, move sequentially from its first rectangular exposure field area A21 to the fourth rectangular exposure field area A24, ... and so on, until moving to the second rectangular exposure field area A92 along the ninth linear exposure path L9.

As shown in FIG. 6 and FIG. 7, in the present invention, when the photomask 10 moves to any rectangular exposure field area relatively, a position of each completely regular hexagonal unit 11 of the photomask 10 corresponds to a position of at least one of the polygonal dies. Since the shape and size of each completely regular hexagonal unit 11 conforms to the overall shape and overall size of a single polygonal die or a combination of multiple polygonal dies of the wafer W, a single polygonal die or multiple polygonal dies can be exposed through each completely regular hexagonal unit 11 of the photomask 10.

In the present invention, when the photomask 10 correspondingly moves to any rectangular exposure field area, duo to that the photomask 10, entirely entering the rectangular exposure field area, has the largest number of completely regular hexagonal units 11, each side of the photomask 10 will partially contact each side of the rectangular exposure field area respectively. As shown in FIG. 6, for example, each long side of the photomask 10 will partially contact and overlap with the long side of the rectangular exposure field area through the edges of each convex portion 12, and each concave portion 13 of each long side of the photomask 10 is located between the convex portions 12 and the long side of the rectangular exposure field area, and similarly, each short side of the photomask 10 will partially contact and overlap with the short side of the rectangular exposure field area through an endpoint of each convex portion 12, and each concave portion 13 of each short side of the photomask 10 is located between the convex portions 12 and the short side of the rectangular exposure field area.

When the photomask 10 moves, along any linear exposure path, correspondingly to any rectangular exposure field are, at least one side of the photomask 10 will partially embed with a corresponding side of the photomask 10 after shifting to an exposure position of another adjacent rectangular exposure area. As shown in FIG. 6 and FIG. 8, for example, assuming that the photomask 10 moves along the linear exposure path L1 to the rectangular exposure field area A11, it is defined that the photomask 10 is located at a first exposure position P1 at this time, and an outer contour of the first exposure position P1 corresponds to a contour of concave and convex edges formed by each side of the photomask 10. Then, the photomask 10 located at the first exposure position P1 is applied for exposing a partial area of the wafer W. After exposing at the first exposure position P1 is completed, the photomask 10 will move correspondingly along the same linear exposure path L1 to another laterally adjacent rectangular exposure field area A12. At this time, it is defined that the photomask 10 is located at a second exposure position P2, and an outer contour of the second exposure position also corresponds to the contour of concave and convex edges formed by each side of the photomask 10.

In this embodiment, a partially overlapping area extending inward from the short side of the rectangular exposure field area A11 overlaps a partially overlapping area extending inward from the relative short side of the laterally adjacent rectangular exposure field area A12, and a lateral width of the aforementioned partially overlapping area is equal to a lateral width of a convex portion 12 or a lateral width of a concave portion 13 formed by the short side of the photomask 10, so that the contour of concave and convex edges of the short side of the photomask 10, as at the first exposure position P1, will partially embed with the contour of concave and convex edges of the short side of the photomask 10, as at the second exposure position P2. Furthermore, the plurality of convex portions 12 of the short sides of the photomask 10, as at the first exposure position P1 of the rectangular exposure field area A11, will partially embed with the plurality of concave portions 13 of the relative short sides of the photomask 10, after correspondingly moving to the laterally adjacent rectangular exposure position P2 of the field area A12. While the plurality of concave portions 13 of the short sides of the photomask 10, as at the first exposure position P1, will partially embed with the plurality of convex portions 12 of the relative short sides of the photomask 10, after correspondingly moving to the laterally adjacent rectangular exposure position P2 of the field area A12. Subsequent operations of moving exposure of the photomask 10 between two laterally adjacent rectangular exposure field areas along the same linear exposure path are also the same. Accordingly, in a step-and-repeat moving exposure process performed by the photomask 10 along the same linear exposure path, it can be ensured that the exposure positions of two laterally adjacent rectangular exposure field areas are completely embedded, so that occurring of exposure gaps is avoided.

As shown in FIG. 6 and FIG. 9, for example, similarly assuming that the photomask 10 moves along the linear exposure path L1 to the rectangular exposure field area A11, it is defined that the photomask 10 is located at the exposure position P1 at this time. And the outer contour of the first exposure position P1 corresponds to the contour of the concave and convex edges of each side of the photomask 10. After the photomask 10 moves to the last rectangular exposure field area A12 along the linear exposure path L1, the photomask 10 will continue to perform step-and-repeat moving along another linear exposure path L2 adjacent to the linear exposure path L1. When the photomask 10 moves along the linear exposure path L2 to another longitudinally adjacent rectangular exposure field area A22, it is defined that the photomask 10 is located at another second exposure position P2, and an outer contour of the second exposure position P2 also corresponds to the contour of the concave and convex edges of each side of the photomask 10.

In this embodiment, a partially overlapping area extending inward from a long side of the rectangular exposure field area A11 overlaps with a partially overlapping area extending inward from a long side of the longitudinally adjacent rectangular exposure field area A22 in another adjacent linear exposure path L2, and a longitudinal width of the partially overlapping area is equal to a longitudinal width of each convex portion 12 and a longitudinal width of each concave portion 13 of the long side of the photomask 10, so that a contour of the concave and convex edges of the long side of the photomask 10 as located at the first exposure position P1 will partially embed with a contour of the concave and convex edges of the long side of the photomask 10 as located at the second exposure position P2. Moreover, the convex portions 12 of the long side of the photomask 10 at the first exposure position P1 of the rectangular exposure field area A11 will embed with the concave portions 13 of the long side of the photomask 10 after shifting to the second exposure position P2 of the rectangular exposure field area A22, and the concave portions 13 of the long side of the photomask 10 at the first exposure position P1 of the rectangular exposure field area A11 will embed with the convex portions 12 of the long side of the photomask 10 after shifting to the second exposure position P2 of the rectangular exposure field area A22. Subsequent operations of moving exposure of the photomask 10 between two longitudinally adjacent rectangular exposure field areas along two linear exposure paths are also the same. Accordingly, in a step-and-repeat moving exposure process performed by the photomask 10 along two linear exposure paths, which are longitudinally adjacent, it can be ensured that the exposure positions of two longitudinally adjacent rectangular exposure field areas are completely embedded, so that occurring of exposure gaps is avoided.

As shown in FIG. 6 and FIG. 10, for example, similarly assuming that the photomask 10 moves along the linear exposure path L1 to the rectangular exposure field area A11, it is defined that the photomask 10 is located at the first exposure position P1 at this time. And the outer contour of the first exposure position P1 corresponds to the contour of the concave and convex edges of each side of the photomask 10. After the photomask 10 shifts to the last rectangular exposure field area A12 along the linear exposure path L1, the photomask 10 will continue to perform step-and-repeat exposure along another linear exposure path L2 adjacent to the linear exposure path L1. exposure. When the photomask 10 moves along the linear exposure path L2 to another diagonally adjacent rectangular exposure field area A21, it is defined that the photomask 10 is located at yet another second exposure position P2. While an outer contour of the second exposure position P2 also corresponds to the contour of the concave and convex edges of each side of the photomask 10.

In this embodiment, a partially overlapping area extending inward from an angle between a long side and a short side of the rectangular exposure field area A11 overlaps with a partially overlapping area extending inward from an angle between a long side and a short side of the diagonally adjacent rectangular exposure field area A21 in another adjacent linear exposure path L2, a lateral width of the partially overlapping area is equal to a lateral width of each convex portion 12 and a lateral width of each concave portion 13 of the short side of the photomask 10, and a longitudinal width of the partially overlapping area is equal to a longitudinal width of each convex portion 12 and a longitudinal width of each concave portion 13 of the long side of the photomask 10, so that a contour near the angle between the long side and the short side of the photomask 10 as located at the first exposure position P1 will partially embed with a contour near the angle between the long side and the short side of the photomask 10 as located at the second exposure position P2. Moreover, the concave portion 13 near the angle between the long side and the short side of the photomask 10 at the first exposure position P1 of the rectangular exposure field area A11 will embed with the convex portion 12 near the angle between the long side and the short side of the photomask 10 after shifting to the second exposure position P2 of the diagonally adjacent rectangular exposure field area A21. Subsequent operations of moving exposure of the photomask 10 between two diagonally adjacent rectangular exposure field areas along two linear exposure paths are also the same. Accordingly, in a step-and-repeat moving exposure process performed by the photomask 10 along two linear exposure paths, it can be ensured that the exposure positions of two diagonally adjacent rectangular exposure field areas are completely embedded, so that occurring of exposure gaps is avoided.

Accordingly, for the wafer exposure layout method of the present invention, by the photomask with a special structural design for cooperating with the plurality of rectangular exposure field areas that are arranged side by side along the straight lines and partially overlap with each other, and by step-and-repeat moving of the photomask along the linear exposure paths relative to the wafer, the exposure positions in two adjacent rectangular exposure fields can fully mate, thereby maximizing an overall utilization of the wafer. Compared with the conventional stepper exposure equipment, the wafer exposure layout method of the present invention can avoid layout errors which will, easily occurred during moving of the photomask between two adjacent rectangular exposure field areas, increase a number of incompletely exposed dies and reduce the wafer utilization.

Please refer to FIG. 5 again. The present invention also discloses a photomask 10 used in the wafer exposure layout method as described above. The photomask 10 is a honeycomb structure composed by a plurality of completely regular hexagonal units 11, so that concave and convex edges form for each side of the photomask 10, and any completely regular hexagonal unit 11 corresponds to at least one of the plurality of polygonal dies. The plurality of completely regular hexagonal units 11 are arranged longitudinally for forming a plurality of rows of completely regular hexagonal unit groups, and any row of completely regular hexagonal unit group is staggered with another adjacent row of completely regular hexagonal unit group, so as to form the honeycomb structure.

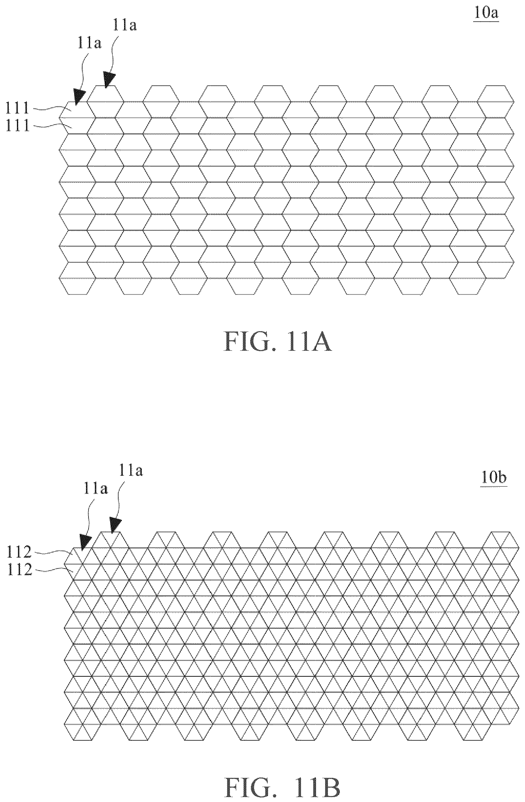

Please refer to FIG. 11A and FIG. 11B together. FIG. 11A is a schematic view of another photomask utilized in another embodiment of the wafer exposure layout method according to the present invention. FIG. 11B is a schematic view of yet another photomask utilized in another embodiment of the wafer exposure layout method according to the present invention. As shown in FIG. 11A and FIG. 11B, a photomask in other embodiments of the present invention, in order to respond to different shapes and sizes of a plurality of polygonal dies pre-formed on a wafer, each completely regular hexagonal unit can be composed of a plurality of polygonal subunits. A shape and a size of each polygonal subunit conforms to the shape and size of a single polygonal die of the wafer.

Taking FIG. 11A as an example, each completely regular hexagonal unit 11a of a photomask 10a is composed of two polygonal subunits 111. Each polygonal subunit 111 is regular trapezoidal, and each polygonal subunit 111 corresponds to a regular trapezoidal die. When the photomask moves correspondingly to any rectangular exposure field area, a position of each polygonal subunit 111 corresponds to a position of a regular trapezoidal die.

Taking FIG. 11B as an example, each completely regular hexagonal unit 11b of the photomask 10b is composed of six polygonal subunits 112. Each polygonal subunit 112 is equilateral triangular, and each polygonal subunit 112 corresponds to an equilateral triangular die. When the photomask moves correspondingly to any rectangular exposure field area, a position of each polygonal subunit 112 corresponds to a position of an equilateral triangular die.

The above implementations are only auxiliary descriptions, and are not intended to limit the embodiments of the application subject or the applications or uses of the embodiments. In addition, although at least one illustrative example has been presented above, it should be understood that the present invention can still have a large quantity of variations. It should also be understood that the embodiments described herein are not intended to limit the scope, use, or configuration of the requested subject matter in any way. On the contrary, the foregoing embodiments will provide a convenient guide for those skilled in the art to implement one or more embodiments. Furthermore, various changes can be made to the function and arrangement of the components without departing from the scope defined by the patent claims, and the scope of the patent claims includes known equivalents and all foreseeable equivalents at the time that the patent application is filed.

## Claims

1. A wafer exposure layout method, for performing step-and-repeat exposing of polygonal dies pre-formed on a wafer, the wafer exposure layout method comprising following steps:
planning a plurality of linear exposure paths that are parallel and equidistant from each other, wherein each linear exposure path includes a plurality of rectangular exposure field areas arranged side by side along a straight line, any of the rectangular exposure field areas partially overlaps an adjacent rectangular exposure field area, and each of the rectangular exposure field areas covers a portion of the wafer;
providing a photomask, composed of a plurality of completely regular hexagonal units to form a honeycomb structure, so that concave and convex edges form for each side of the photomask, wherein each completely regular hexagonal unit corresponds to at least one of the plurality of polygonal dies; and
moving the photomask one by one along a plurality of linear exposure paths relative to the wafer, wherein when the photomask moves along any of linear exposure paths, it is moved one by one along the plurality of rectangular exposure field areas which are side by side, to expose the wafer;
wherein when the photomask correspondingly moves to a first exposure position of any of the rectangular exposure field areas, each side of the photomask partially contacts each side of the rectangular exposure field area, and wherein when the photomask moves to a second exposure position in another adjacent rectangular exposure field area, at least one side of the photomask partially embed with a corresponding side of the adjacent rectangular exposure field area.

2. The wafer exposure layout method as claimed in claim 1, wherein a plurality of convex portions and a plurality of concave portions are respectively formed for each side of the photomask, and wherein the plurality of convex portions of at least one side of the photomask, as being moved to the first exposure position in any of the rectangular exposure field areas, are partially embedded with the plurality of concave portions of a correspondingly side of the photomask, being relatively moved to the second exposure position in another adjacent rectangular exposure field area, and the plurality of concave portions of the at least one side of the photomask are partially embedded with the plurality of convex portions of the correspondingly side of the photomask, being relatively moved to the second exposure position in another adjacent rectangular exposure field area.

3. The wafer exposure layout method as claimed in any of the previous claims, wherein a partially overlapping area extending inward from a short side of any of the rectangular exposure field areas overlaps a partially overlapping area extending inward from a short side of another laterally adjacent rectangular exposure field area, in each of the linear exposure paths.

4. The wafer exposure layout method as claimed in any of the previous claims, wherein a partially overlapping area extending inward from a long side of any of the rectangular exposure field areas in each of the linear exposure paths overlaps a partially overlapping area extending inward from a long side of another longitudinally adjacent rectangular exposure field area in another of the linear exposure paths.

5. The wafer exposure layout method as claimed in any of the previous claims, wherein a partially overlapping area extending inward from an angle between a long side and a short side of any of the rectangular exposure field areas in each of the linear exposure paths overlaps a partially overlapping area extending inward from an angle between a long side and a short side of another diagonally adjacent rectangular exposure field area in another of the linear exposure paths.

6. The wafer exposure layout method as claimed in any of the previous claims, wherein when the photomask is correspondingly moved to any of the rectangular exposure field areas, a position of any of the completely regular hexagonal units corresponds to a position of at least one of the plurality of polygonal dies.

7. The wafer exposure layout method as claimed in any of the previous claims, wherein each completely regular hexagonal unit is composed of a plurality of polygonal subunits, and wherein when the photomask is correspondingly moved to any of the rectangular exposure field areas, a position of any of the polygonal subunits corresponds to a position of at least one of the plurality of polygonal dies.

8. The wafer exposure layout method as claimed in claim 7, wherein each of the polygonal subunit is equilateral triangular or regular trapezoidal.

9. The wafer exposure layout method as claimed in any of the previous claims, wherein each of the polygonal dies is equilateral triangular, equilateral trapezoidal or regular hexagonal.

10. The wafer exposure layout method as claimed in any of the previous claims, wherein a plurality of rows of completely regular hexagonal unit groups are formed by the plurality of completely regular hexagonal units, and any of the rows of completely regular hexagonal unit groups is connected to another adjacent row of completely regular hexagonal unit group in a staggered manner, so as to form the honeycomb structure.

11. A photomask utilized in the wafer exposure layout method as claimed in claims 1 to 10, composed by a plurality of completely regular hexagonal units to form a honeycomb structure, so that concave and convex edges form for each side of the photomask, and wherein each of the completely regular hexagonal unit corresponds to at least one of a plurality of polygonal dies.
